# EUROPEAN PATENT SPECIFICATION

(11) **EP 0 521 296 B1**
(45) Date of publication and mention of the grant of the patent: **27.12.1995**
(21) Application number: 92108806.8
(22) Date of filing: 26.05.1992
(51) Int. Cl.: G03F 7/11, G03F 7/00, G03H 1/02

(54) **Protected photosensitive recording films**
Beschützte lichtempfindliche Filme
Films photosensibles protégés

(30) Priority: 31.05.1991 US 708402
(43) Date of publication of application: 07.01.1993
(73) Proprietor: Hughes Aircraft Company, Los Angeles, California 90045-0066 (US)
(72) Inventor: Yu, Kevin, Temple City, California 91780 (US); Yin, Khin S., Alhambra, California 90801 (US); Mulder, Jerry L., Arcadia, California 91007 (US)
(74) Representative: Weller, Wolfgang, Dr.rer.nat.

(56) References cited:
- EP-A- 0 291 928
- DE-A- 3 728 736
- US-A- 4 072 527
- US-A- 4 315 665
- US-A- 4 789 211
- US-A- 4 963 471
- Zelikman & Levi;Making and Coating Photographic Emulsion,Focal Press,New York & London,P 13-15

## Description

The present invention relates in general to photosensitive polymer films which are used for recording high efficiency holograms. More particularly, the present invention relates to the protection of such photosensitive polymer films during the preparation and use of high efficiency holograms.

Reflective display holograms are one of the most commonly recorded holograms. These holograms have found utility in a wide variety of applications. In addition to their ornamental utility in pendants and jewelry, these holograms are also useful in optical display devices such as head-up displays and windshields which are designed to project images to a viewer. Reflective display holograms operate in the reflective mode and can be illuminated for visualization with white light without significant loss of resolution.

Reflective display holograms traditionally have been prepared by recording the hologram on a dichromated gelatin recording medium and subsequently processing the recording to form the hologram. The dichromated gel recording systems consist of a film of the photosensitive material on a glass or a rigid optical quality polymeric substrate. During the recording process an object wave is reflected from a mirror located a short distance beyond the photosensitive recording system. The reflected object wave and a reference wave form interference fringes which are recorded on the film of dichromated gel.

To provide a high efficiency recording, steps must be taken to assure that the object wave is not refracted or bent by materials having refractive indexes which are different than those of the dichromated gel and its substrate. Most solid optical quality materials suitable for forming the substrate have refractive indices greater than 1.4. Thus, the space between the dichromated gel recording medium and the mirror cannot be air which has a refractive index close to 1. Immersion oils carefully formulated to a specific refractive index are typically used as convenient filler materials for this space. Since dichromated gel is a water based recording medium and the immersion oils are immiscible with water and do not interact with water, the immersion oils do not destroy or interfere with the function of the dichromated gel. Thus, the practice of using immersion oils in close contact with dichromated gel presents no problem with recording high resolution holograms.

A persistent problem presented by dichromated gel holograms is their inherent susceptibility to attack by moisture. Due to the water soluble nature of the gels, great care must be taken during processing and subsequent use to insure that moisture is not present.

Recently, polymeric photosensitive recording mediums have been developed which overcome the moisture related problems associated with dichromated gels. These polymeric recording mediums are available from DuPont in Wilmington, Delaware, and are generally referred to as holographic recording film (HRF). The exact composition of the polymeric recording mediums is maintained as proprietary information by the film manufacturers. However, the polymeric recording films are known generally to include polymeric material, photoreactive monomers, initiators, plasticizers and other additives.

One type of HRF is marketed by Dupont Co. Imaging Systems, Wilmington, Delaware under the trade name OMNIDEX. OMNIDEX polymeric recording medium is available as a liquid which can be applied to various surfaces to form an HRF. OMNIDEX polymeric recording medium is also available as a prefabricated film which is sandwiched between two protective layers of MYLAR® brand polyester.

Holographic recording films are inherently resistant to attack by moisture. Accordingly, they are well suited for use in making high efficiency holograms which may intentionally or inadvertently come into contact with moisture. One problem with these new polymer based films is that they are not resistant to immersion oils, many organic solvents, and other organic based materials. This susceptibility to immersion oils and organic solvents has presented a number of problems with respect to processing and use of these new materials.

The HRF-MYLAR® laminates available from Dupont Co. provide adequate protection of the polymer film during exposure to immersion oils. However, MYLAR® is a relatively inflexible material which is not well suited for use on curved hologram substrates. In addition, MYLAR® has a certain amount of birefringence activity which interferes with visualization of the hologram.

Head-up display combiners and most windshields are laminated structures which include one or more holograms sandwiched between layers of glass or plastic. The various layers are laminated together utilizing various optical adhesives such as polyvinyl butyral. We have determined that unprotected polymeric recording films, when used in such laminate structures, are gradually attacked by plasticizers and other ingredients present in the optical adhesives. This results in a gradual degradation of the hologram and its optical quality. MYLAR® layers could be used to protect the HRF from attack by the optical adhesives. However, MYLAR® would not be suitable for use in curved combiners or windshields.

In the art of traditional photography involving gelatine-based silver halide emulsions it is basically known to provide a protective layer on top of the photosensitive layer. Common protective layers are for example gelatine or PVA layers containing minor amounts of various other ingredients (confer V.L. Zeilman et al., Making and Coating Photographic Emulsions, Focal Press, London, GB, 1964, pp. 13 through 14).

From US-A-4 963 471 and from US-A-4 072 527 it is basically known to prepare a protected photosensitive recording film comprising an optically clear support such as a polyethylene terephthalate film, polymethyl methacrylate, cellulose triacetate, or polyester by coating such an optically clear support with a photosensitive material and providing a protective coversheet, such as polyethylene or polypropylene film thereon.

It is an object of the invention to provide a way of protecting polymeric recording mediums from immersion oils during fabrication wherein the resulting protected film could be used to create high efficiency holograms on either curved or flat substrates. It would also be desirable to provide a way to protect polymeric recording mediums from gradual attack by optical adhesives when the polymeric recording medium is used in either a flat or curved laminate.

In accordance with the present invention, a polymeric recording film is provided which is protected from attack by immersion oils used during hologram processing. The film is also protected from subsequent attack by optical adhesives or other materials containing organic solvents or the like. The protected film can be used on either curved or flat substrates.

The present invention is based on the discovery that certain water based polymer materials can be used to form protective barriers for polymer recording mediums used to record holograms. These water based protective barriers are effective in protecting photosensitive recording materials from refractive index matching oils and other organic based materials. It was further discovered that the water based polymers were sufficiently flexible to allow their use as protective barriers on curved as well as flat substrates.

As one feature of the present invention a layer of photosensitive material is located between two water based polymeric protective barriers. As another feature of the present invention, the photosensitive recording material can be located between an outer surface of a substrate and a water based polymeric protective barrier.

The protected photosensitive recording films of the present invention can be prepared by first spinning, spraying, dipping or drawing a solution of water based polymer to form a protective barrier. A layer of photosensitive material can then be similarly formed on the water based polymeric protective barrier. Finally, a second water based polymeric protective barrier can be formed on the layer of photosensitive material.

Alternatively, the photosensitive material can be first spray coated, spin coated, or dip coated onto a substrate to form a layer of photosensitive material. Then a solution of water based polymer is similarly applied to the photosensitive material to form a protective barrier

Once exposed and processed the protected photosensitive recording film of the present invention can be used in a variety of structures including curved windshields and curved combiners.

The above-discussed and many other features and attendant advantages of the present invention will become apparent as the invention becomes better understood by reference to the following detailed description when considered in conjunction with the accompanying drawings.

FIG. 1 is a representation of a protected photosensitive recording film in accordance with the present invention showing a layer of photosensitive material between two protective barriers.

FIG. 2 is a representation of a protected photosensitive recording film in accordance with the present invention showing a flat substrate, a layer of photosensitive material, and a protective barrier.

FIG. 3 is a representation of a preferred photosensitive recording film showing a curved substrate, a layer of photosensitive material, and a protective barrier.

FIG. 4 is a representation of a optical display incorporating a protected photosensitive recording film.

The present invention provides protected photosensitive recording films which may be used in preparing holograms on both flat and curved glass substrates such as those incorporated in head-up optical displays.

The present invention is based upon the discovery that certain optical quality water based polymer films can provide effective protective barriers for organic solvent based photosensitive polymer materials. Since these films can be incorporated in photosensitive recording films mounted on curved substrate surfaces, they are also suitable for use in recording systems which are utilized to prepare holograms in optical displays having curved configurations.

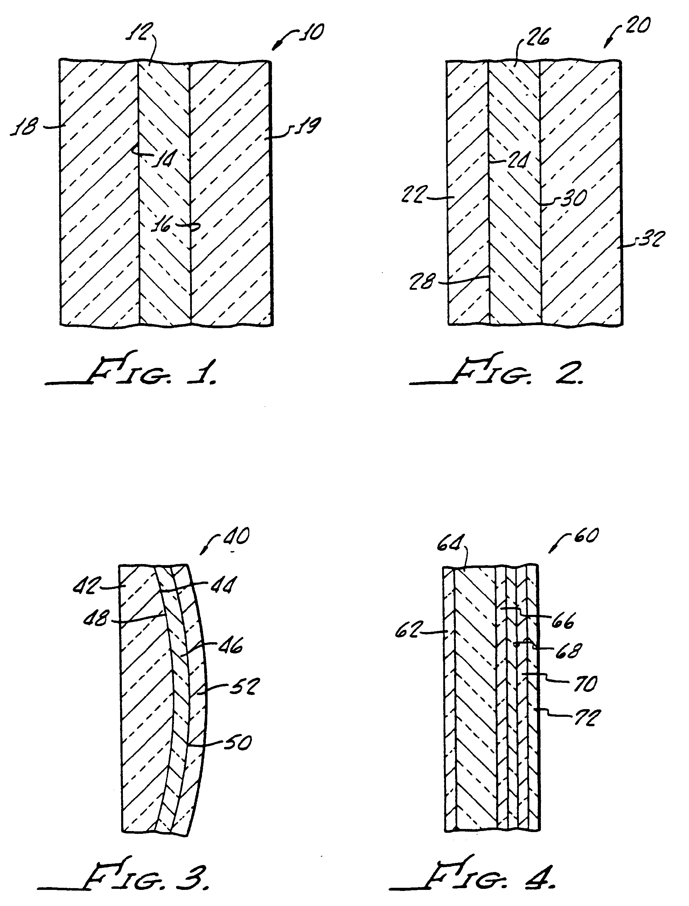

FIG. 1 illustrates an exemplary protected photosensitive film 10 according to the present invention. The protected film includes a layer of photosensitive material 12 having two surfaces 14, 16 and a refractive index. Optically clear water based polymeric protective barriers 18 and 19 having refractive indexes substantially similar to the refractive index of the photosensitive material 12 are located on surfaces 14 and 16, respectively, of the photosensitive material 12.

In accordance with the present invention, the layer of photosensitive material 12 is preferably a layer of holographic recording photopolymer. These photopolymers are typically films of polymer, monomeric compounds, capable of reacting in the presence of light, photoinitiators and other suitable additives. A particularly suitable photosensitive material is a photopolymer system marketed by Dupont under the trade name Omnidex. Omnidex is a solution of polymer, acrylate monomers, photoinitiators, vinyl carbazole in a solvent base. Other photosensitive materials, including dichromated gel are also suitable for use in the photosensitive recording system of the present invention.

The thickness of the layer of photosensitive material will vary with the type of material selected. Generally, however, the layer is of a uniform thickness ranging from about 4 »m to about 35 »m. In order for light to effectively pass through the photosensitive recording system, the refractive index is preferably substantially the same as that of the optically clear substrate. More particularly, the refractive index of the layer of photosensitive should be within about ± 0.01 of the substrate refractive index.

In accordance with the present invention, the optically clear protective barriers 18 and 19 are layers of material having a refractive index substantially the same as the refractive index of the photosensitive material. Preferably, each of the protective barriers 18 and 19 is a film of material which is insoluble and non-reactive with organic oils , such as the refractive index immersion oils used in connection with recording holograms. The protective barriers 18 and 19 are also preferably insoluble and non-reactive with organic plasticizers and adhesives such as those used in windshield laminates. Moreover, the optically clear protective barrier must remain in close contact with the photosensitive material without pealing or forming voids. Thus, the protective barrier material preferably forms good adhesive bonds with the photosensitive material while remaining otherwise inert to the photosensitive material.

Additionally, as discussed below, the protective barriers utilized in the photosensitive recording systems of the present invention are preferably films capable of being formed by spin coating, dipping, or spraying solutions containing protective barrier material to the outer surface of the layer of photosensitive material. Accordingly, suitable protective barriers are soluble film-forming polymers capable of forming optically clear films which adhere to the photosensitive material of choice. Water soluble film forming polymers are particularly suitable since the aqueous solvent is inert toward most photosensitive recording systems and organic oils. Typical water soluble polymers which can be utilized in accordance with the present invention are gelatin, starches, polyvinylalcohols, polyvinylpyrrolidone, and water soluble polyacrylates.

When, for example, Omnidex photopolymer is used as the layer of photosensitive material 12, the optically clear protective barriers 18 and 19 are preferably a polyvinylalcohol. A particularly suitable polyvinylalcohol is available from Bakers Chemical and has a 99 - 99.8 % degree of hydrolysis. This specific degree of hydrolysis results in a polymeric material which is water soluble but not highly hydrophilic. The lower degree of hydrophilicity provides a certain degree of resistance to the formation of tacky and gel-like films. Advantageously, polyvinylalcohol has a refractive index very near the refractive index of Omnidex films (1.51) and aqueous solutions of polyvinylalcohol adhere to Omnidex films when applied using spin coating, dipping, or spraying techniques.

The thickness of the optically clear protective barriers 18 and 19 are preferably as thick as necessary to prevent any interaction between the photosensitive material and the environment. As described below, the thickness of the protective barrier can be limited by the methods used to form the films and the particular choice of solvent. However, protective barriers having thicknesses of about 5 microns and greater are known to be effective barriers. Preferably the barriers are on the order of 0.5 mil (1.3 x 10⁻³cm) to 2 mil (5.2 x 10⁻³cm) thick.

Turning now to FIG. 2 there is illustrated another exemplary embodiment of the present invention, a protected photosensitive recording film 20. The system includes an optically clear substrate 22 having a substrate refractive index and an outer surface 24. A layer of photosensitive material 26 having an refractive index substantially the same as the substrate refractive index is located on the outer surface 24 of the optically clear substrate 22. The photosensitive material 26 has an inner surface 28 adjacent to the rigid optically clear substrate, and an outer surface 30.

An optically clear protective barrier 32 is adhered to the outer surface 30 of the photosensitive material 26. The optically clear protective barrier 32 also has a refractive index which is substantially the same as the substrate refractive index.

The optically clear substrate 22 can be formed from any material having physical and chemical characteristics suitable for the intended application of the recorded hologram. For most applications the preferred substrate material is a combination of one or more inorganic glasses, such as silica, BK-7 and B-270. Advantageously these glasses have excellent optical clarity and can be prepared in a variety of thicknesses and configurations. Accordingly, substrates can conveniently range from very thin glass ornaments of less than a millimeter to relatively thick optical displays on the order of inches. For reasons which will be discussed later, it is also advantageous that compositions of inorganic glasses can be varied to change the refractive index of the substrate.

For applications in which the substrate preferably is very light weight, it is also within the scope of the present invention to utilize substrates prepared of organic polymers having a high degree of optical clarity such as polycarbonate. Polycarbonate has a substantially lower density than inorganic glasses and is used extensively in optical lenses because of its light weight and excellent optical characteristics.

Turning to FIG. 3, there is illustrated a preferred photosensitive recording system 40 having a rigid optically clear substrate 42 having a curved outer surface 44 and a substrate refractive index. A layer of photosensitive material 46 is located on the curved outer surface 44 of the rigid optically clear substrate. The layer of photosensitive material 46 has a curved inner surface 48 adjacent to the rigid optically clear substrate 42, a curved outer surface 50, and a refractive index substantially the same as the substrate refractive index. A optically clear curved protective barrier 52 is adhered to the curved outer surface 50 of the photosensitive material. The optically clear protective barrier 52 has as refractive index substantially the same as the substrate refractive index.

The preferred embodiment of FIG. 3 is similar to that illustrated in FIG. 2 with the exception of the curved outer surface 44 of the optically clear substrate 42, the curved outer surface 50 and the curved inner surface 48 of the layer of photosensitive material 46, and the protective barrier 52. The representative and preferred materials described above for FIGS. 1 and 2 are equally applicable to each of the elements described for FIG. 3.

Photosensitive recording systems having curved substrates such as that described in Fig 3 are particularly adaptable to the teachings of the present invention because the protective barrier 52, and the layer of photosensitive material 46 are advantageously prepared in the form of a laminate, without voids or air pockets, which interfere with the function of the photosensitive recording system.

As mentioned earlier, in accordance with the present invention, the optically clear protective barrier serves to prevent interactions between the photosensitive material and the immediate environmental surroundings, such as refractive index immersion oils. Even though water soluble film forming polymers are the preferred materials for their resistance to oils and the ease at which adherent films can be applied to layers of photosensitive materials, other types of materials can also be utilized. For example, KEL-F available from 3M, is a polychlorotrifluoroethylene, which is soluble in freon and impermeable and non-reactive with organic oils and many organic solvents.

Another class of suitable materials for the protective barriers are thin flexible optically clear films of oil insoluble polymers which are available in a suitable refractive index and are stable in the presence of organic solvents and oils can be an effective barrier material. Preformed films of these insoluble polymers can be made to adhere to both curved and flat surfaces through surface energy interactions. One such material is the family of optically clear silicone elastomers.

Similarly, thin flexible films of inorganic glasses can be effective materials for protective barriers. Such glasses have good bending strength and can be made to adhere to flat as well as curved surfaces through surface energy interactions. As previously mentioned inorganic glasses are available in a variety of refractive indices depending upon the type of glass.

The protected photosensitive recording films of the present invention can be assembled using techniques known in the art for forming laminates or layered devices.

The first step in preparing a protected photosensitive recording film according to FIG. 1 is to form a first protective barrier having an outer surface. The subsequent steps are to form a layer of photosensitive material having an outer surface on the outer surface of the protective barrier and to adhere a second protective barrier on the outer surface of the layer of photosensitive material. As discussed below in connection with the preparation of the protected photosensitive recording films shown in FIGS. 2 and 3, the layer of photosensitive material and the protective barriers can be formed using techniques such as spraying, dipping, spinning and drawing. In accordance with the present invention the protected recording films shown in FIGS. 2 and 3 can be prepared according to the following steps. The first step is to provide an optically clear substrate having an outer surface and having a substrate refractive index. The subsequent step is to form a layer of photosensitive material, having a refractive index substantially the same as the substrate refractive index, on the outer surface of the rigid optically clear substrate. The photosensitive material has an inner surface adjacent to the substrate outer surface and an opposite outer surface.

In accordance with the present invention forming a layer of photosensitive material can be carried out by spin coating, dip coating, or spray coating solutions or gels containing the photosensitive material on to the optically clear substrate. According to the preferred embodiment, photopolymers in organic solvent solutions can be spin coated onto either a flat optically clear substrate or a curved optically clear substrate in a dark room environment. Most procedures carried out according to the teachings of the present invention will result in small amounts of solvent remaining in the layer of photosensitive material. Residual solvent content up to approximately 0.05% has no adverse effect.

After forming a layer of photosensitive material on the optically clear substrate, the next step is to adhere an optically clear protective barrier to the outer surface of the photosensitive material. According to the present invention adhering an optically clear protective barrier to the outer surface of the photosensitive material can be accomplished by spray coating, dip coating, or spin coating a solution of protective barrier material in a suitable solvent onto the outer surface of the layer of photosensitive material.

An associated method of adhering the protective barrier material to the layer of photosensitive material is to place a thin layer of suitable protective barrier material in very close contact with the outer surface of the layer of photosensitive material. As mentioned above, certain materials will adhere to other materials by surface energy interactions without forming voids between the two materials. For example, clear thin films of silicone elastomer having a refractive index substantially the same as the optically clear substrate and photosensitive material can be carefully placed in close contact with the layer of photosensitive material. The tacky nature of the silicone will cause it to remain tightly adhered to the outer surface of the photosensitive material.

After the photosensitive recording system is assembled the hologram is prepared by exposing the layer of photosensitive material using techniques commonly used in the art. When the photosensitive material is photopolymer, for example Omnidex, the photosensitive recording system is then preferably exposed to an overall white light to fix the non-imaged area of the film. Then the system is baked in an oven to further cure the material and increase the diffraction efficiency.

Photosensitive recording systems prepared according to the teachings of the present invention are useful in any application in which photosensitive materials are preferably layered on rigid optically clear substrates. As described above, photopolymer recording systems used to record reflective holograms in the presence of immersion oils find particular utility in head-up optical displays. High efficiency holograms can be recorded on the photopolymer recording systems of the present invention and subsequently developed and incorporated into head-up display devices.

FIG. 4 illustrates a head-up optical display 60 which incorporates a hologram recorded on the photosensitive recording system of the present invention. As a feature of the present invention, the protective barrier can be left in place or it can be removed prior to incorporating the hologram in the optical display device. In the head-up optical display 60 of FIG. 4 a layer of optical display coating 62 is located on an outer surface of a rigid optically clear substrate 64. A layer of exposed and processed photosensitive material 66 is located on an inner surface of said rigid optically clear substrate 64 and a protective barrier 68 is located on an outer surface of the exposed and processed photosensitive material 66. A layer of optical adhesive 70 adheres a layer of optically clear material 72 to an outer surface of the protective barrier.

The rigid optically clear substrate 64, the layer of exposed and processed photosensitive material 66, and the protective barrier 68 comprise a photosensitive recording system as described above. The optical display coating is preferably an antireflection coating such as MgF₂ and the layer of optically clear material is preferably a glass. The optical adhesive is preferably NOA68, from Norland Product.

The head-up optical display 60 can be assembled after the hologram has been exposed and processed. Optionally, the protective barrier can be removed prior to assembling the head-up optical display. This is particularly preferred when the protective barrier may lose its adhesive integrity with time.

The following examples illustrate methods and materials which are useful in the practice of the present invention.

### Example 1

A photosensitive recording system was prepared by first ultrasonically cleaning a 10.16 cm x 12.7 cm x 0.635 cm (4˝ x 5˝ x 1/4˝) flat piece of glass having a refractive index of 1.51. The piece of glass was then rinsed with deionized water and solvent dried with acetone. Omnidex was spin coated on the flat surface using a LS510PC Headway Spinner. This was accomplished by pouring the solution onto the center of the piece of glass, levelling the glass and flooding for 10 seconds. Then the solution was spun off at 200 RPM for 3 minutes to give a thickness of 10 »m. The glass substrate was then stacked vertically in a closed container away from light. The refractive index of the dried layer of photopolymer was 1.51.

A solution of polyvinylalcohol was prepared by dissolving 20 gm of polyvinylalcohol (PVA) in 100 ml of water. The PVA had a degree of hydrolysis of 99 - 99.8%. The solution was spun coated over the layer of dried photopolymer at 1000 RPM and dried in a nitrogen environment for approximately 30 minutes to achieve at least 0.013 mm (0.5 mil) thickness and a refractive index of 1.51.

This photosensitive recording system was then exposed to a holographic exposure system using a method of index matching oil to prevent noise holograms from surface reflections. The polyvinylalcohol acted as a barrier from the index matching oil, protecting the photopolymer during the long stabilization and exposure period. After the exposure, the photosensitive recording system was rinsed with freon to remove the indexing matching the oil. and then exposed to UV/white light for 30 minutes at 5mW/cm². Finally, the system was baked at 100°C in an air convection oven which brought the holographic efficiency to above 95%.

### Example 2

A photosensitive recording system was prepared utilizing an optically clear glass substrate having a curved surface utilizing the same procedure and materials described for Example 1 with the exception of the spin coating method. To spin coat the Omnidex photopolymer solution and the polyvinylalcohol solution was spun onto the substrate utilizing a moving arm dispenser system in an outbound mode at 200 RPM.

Having thus described exemplary embodiments of the present invention, it should be noted by those skilled in the art that the within disclosures are exemplary only and that various other alternatives, adaptations and modifications, may be made within the scope of the present invention. Accordingly, the present invention is not limited to the specific embodiments as illustrated herein, but is only limited by the following claims.

## Claims

1. A protected photosensitive recording film useful for recording holograms, comprising:
- a layer of photosensitive material (12; 26; 46; 66) having two sides (14, 16; 24, 30; 44, 48) and a refractive index; and
- an optically clear water based polymeric protective barrier (18, 19; 32; 52; 68) located on at least one side (14, 16; 30; 50) of said photosensitive material (12; 26; 46; 66), said protective barrier (18, 19; 32; 52; 68) having a refractive index substantially the same as the refractive index of said layer of photosensitive material (12; 26; 46; 66);
characterized by an optically clear substrate (22; 42; 64) located on one side of said photosensitive material (26; 46; 66), said optically clear substrate (22; 42; 64) having a refractive index substantially similar to said refractive index of said layer of photosensitive material (26; 46; 66).

2. The film of claim 1, charaterized in that said substrate (22; 42; 64) is glass and said refractive index is approximately 1,51.

3. The film of claim 1, characterized in that said optically clear substrate (22; 42; 64) is polycarbonate.

4. The film of any of claims 1 - 3, characterized in that said layer of photosensitive material (12; 26; 46; 66) is a layer of holographic recording photopolymer.

5. The film of any of claims 1 - 4, characterized in that said layer of photosensitive material (12; 26; 46; 66) has a refractive index of approximately 1,51.

6. The film of any of claims 1 - 5, characterized in that said protective barrier (18, 19; 32; 52; 68) is a water soluble polymer selected from the group consisting of polyvinylalcohol, gelatin and polyvinylpyrrolidone.

7. The film of claim 6, characterized in that said water soluble polymer is polyvinylalcohol.

8. The film of claim 7, characterized in that said polyvinylalcohol has a refractive index of approximately 1,51.

9. A protected photosensitive recording film useful for recording holograms, comprising:
- an optically clear glass substrate (22; 42; 64) having an outer surface (24), said optically clear glass substrate (22; 42; 64) having a refractive index of approximately 1,51;
- a layer of photosensitive material (26; 46; 66) located on the outer surface (24) of said optically clear glass substrate (22; 42; 64), said layer of photosensitive material (26; 46; 66) comprising a mixture of polymer, acrylate monomers, initiators, and additives, said layer of photosensitive material (26; 46; 66) having an inner surface (24; 48) adjacent to said optically clear glass substrate (22; 42; 64) and an outer surface (30; 50), said layer of photosensitive material (26; 46; 66) having a refractive index of approximately 1,51; and
- a polyvinylalcohol protective barrier (32; 52; 68) adhered to said outer surface (30; 50) of said layer of photosensitive material (26; 46; 66), said polyvinylalcohol protective barrier (32; 52; 68) having a minimum thickness of approximately 0,5 mils (13»m) and having a refractive index of approximately 1,51.

10. The film of any of claims 2 or 9, characterized in that said optically clear glass substrate (42) has at least one curved outer surface.

11. The film of any of claims 2 or 9, characterized in that said optically clear glass substrate (22; 64) has two flat planar surfaces (24).

12. A method for preparing a protected photosensitive recording film, comprising the steps of:
- forming an optically clear water based polymeric protective barrier (18) having an outer surface;
- forming a layer of photosensitive material (12) on said outer surface of said optically clear water based polymeric protective barrier (18), said photosensitive material (12) having an outer surface (16); and
- adhering an optically clear protective barrier (19) to said outer surface (16) of said photosensitive material (12).

13. A holographic head-up optical display, comprising:
- a layer of optical display coating (62) having an outer surface;
- a rigid optically clear substrate (64) located on said outer surface of said layer of head-up optical display coating (62), said rigid optically clear substrate (64) having an outer surface;
- a layer of exposed and processed photosensitive material (66) located on said outer surface of said rigid optically clear substrate (64), said layer of exposed and processed photosensitive material (66) having an inner surface adjacent said rigid optically clear substrate (64) and an outer surface;
- an optically clear protective barrier (68) located on said outer surface of said exposed and processed photosensitive material (66), said optically clear protective barrier (68) having an inner surface adjacent said exposed and processed photosensitive material (66) and an outer surface; and
- a layer of optical adhesive (70) located on said outer layer of said optically clear protective barrier (68), said optical adhesive (70) adhering a layer of optically clear material (72) to said outer surface of said protective barrier (68).

14. The head-up optical display of claim 13, characterized in that said outer layer of optically clear substrate (64) is selected from the group of materials comprising inorganic glasses and optical quality organic polymers.

15. The head-up optical display of claim 13 or 14, characterized in that said layer of exposed and processed photosensitive material (66) is exposed and processed holographic recording photopolymer.

16. The head-up optical display of any of claims 13 - 15, characterized in that said protective barrier (68) is polyvinylalcohol having a thickness of at least 0,5 mil (13 »m).

17. The head-up optical display of any of claims 13 - 16, characterized in that said optical display coating (62) is an antireflection coating.

18. A hologram comprising a holographic recording film having two sides and a refractive index, characterized by protecting the holographic recording film on at least one side with a layer of a water soluble polymer which has a refractive index being substantially the same as the refractive index of said holographic recording film.

19. The hologram of claim 18, characterized in that said water soluble polymer is polyvinylalcohol.

20. The hologram of claim 18 or 19, characterized in that said holographic recording film is a photopolymer.

## Patentansprüche

1. Geschützter lichtempfindlicher Aufnahmefilm, verwendbar zur Aufnahme von Hologrammen, umfassend:
- eine Schicht lichtempfindlichen Materials (12; 26; 46; 66) mit zwei Seiten (14, 16; 24, 30; 44, 48) und einem Brechnungsindex; und
- eine optisch klare polymere Schutzbarriere (18, 19; 32; 52; 68) auf Wasserbasis, die an wenigstens einer Seite (14, 16; 30; 50) des lichtempfindlichen Materials (12; 26; 46; 66) vorgesehen ist, wobei die Schutzbarriere (18, 19; 32; 52; 68) einen Brechnungs-index aufweist, der im wesentlichen derselbe wie der Brechnungsindex der Schicht des lichtempfindlichen Materials (12; 26; 46; 66) ist,
gekennzeichnet durch ein optisch klares Substrat (22; 42; 64), das auf einer Seite des lichtempfindlichen Materials (26; 46; 66) angeordnet ist, wobei das optisch klare Substrat (22; 42; 64) einen Brechnungsindex aufweist, der im wesentlichen ähnlich dem Brechungsindex der Schicht des lichtempfindlichen Materials (26; 46; 66) ist.

2. Film nach Anspruch 1, dadurch gekennzeichnet, daß das Substrat (22; 42; 64) Glas ist und einen Brechnungsindex von ungefähr 1,51 aufweist.

3. Film nach Anspruch 1, dadurch gekennzeichnet, daß das optisch klare Substrat (22; 42; 64) Polycarbonat ist.

4. Film nach irgendeinem der Ansprüche 1 bis 3, dadurch gekennzeichnet, daß die Schicht des lichtempfindlichen Materials (12; 26; 46; 66) eine Schicht eines holographischen Aufnahme-Photopolymers ist.

5. Film nach irgendeinem der Ansprüche 1 bis 4, dadurch gekennzeichnet, daß die Schicht des lichtempfindlichen Materials (12; 26; 46; 66) einen Brechnungsindex von ungefähr 1,51 aufweist.

6. Film nach irgendeinem der Ansprüche 1 bis 5, dadurch gekennzeichnet, daß die Schutzbarriere (18, 19; 32; 52; 68) ein wasserlösliches Polymer ist, das aus der Gruppe bestehend aus Polyvinlyalkohol, Gelatine und Polyvinylpyrrolidon ausgewählt ist.

7. Film nach Anspruch 6, dadurch gekennzeichnet, daß das wasserlösliche Polymer Polyvinylalkohol ist.

8. Film nach Anspruch 7, dadurch gekennzeichnet, daß der Polyvinylalkohol einen Brechnungsindex von ungefähr 1,51 aufweist.

9. Geschützter lichtempfindlicher Aufnahmefilm, verwendbar zur Aufnahme von Hologrammen, umfassend:
- ein optisch klares Glassubstrat (22; 42; 64) mit einer äußeren Fläche (24), wobei das optisch klare Glassubstrat (22; 42; 64) einen Brechungsindex von ungefähr 1,51 aufweist;
- eine Schicht von lichtempfindlichem Material (26; 46; 66), die an der äußeren Fläche (24) des optisch klaren Glassubstrates (22; 42; 64) vorgesehen ist, wobei die Schicht des lichtempfindlichen Materials (26; 46; 66) eine Mischung aus Polymer, Acrylatmonomeren, Initiatoren und Additiven umfaßt, wobei die Schicht des lichtempfindlichen Materials (26; 46; 66) eine Innenfläche (24; 48) aufweist, die an das optisch klare Glassubstrat (22; 42; 64) und an eine Außenfläche (30; 50) angrenzt, wobei die Schicht des lichtempfindlichen Materials (26; 46; 66) einen Brechungsindex von ungefähr 1,51 aufweist und
- eine Schutzbarriere (32; 52; 68) aus Polyvinylalkohol, die an der Außenfläche (30; 50) der Schicht des lichtempfindlichen Materials (26; 46; 66) anhaftet, wobei die Schutzbarriere (32; 52; 68) aus Polyvinylalkohol eine Mindestdicke von ungefähr 0,5 mils (13 »m) und einen Brechungsindex von ungefähr 1,51 aufweist.

10. Film nach irgendeinem der Ansprüche 2 oder 9, dadurch gekennzeichnet, daß das optisch klare Glassubstrat (42) wenigstens eine gekrümmte Außenfläche aufweist.

11. Film nach irgendeinem der Ansprüche 2 oder 9, dadurch gekennzeichnet, daß das optisch klare Glassubstrat (22; 64) zwei flache ebene Flächen (24) aufweist.

12. Verfahren zum Herstellen eines geschützten lichtempfindlichen Aufnahmefilms, umfassend die Schritte:
- Formen einer optisch klaren, polymeren Schutzschicht (18) auf Wasserbasis, die eine Außenfläche aufweist;
- Formen einer Schicht von lichtempfindlichem Material (12) auf der Außenfläche der optisch klaren, polymeren Schutzbarriere (18) auf Wasserbasis, wobei das lichtempfindliche Material (12) eine Außenfläche (16) aufweist; und
- Befestigen einer optisch klaren Schutzbarriere (19) auf der Außenfläche (16) des lichtempfindlichen Materials (12).

13. Holographisches, optisches Headup-Display, umfassend:
- eine Schicht einer optischen Anzeigebeschichtung (62) mit einer Außenfläche;
- ein festes, optisch klares Substrat (64), das auf der Außenfläche der Schicht der optischen Headup-Display-Beschichtung (62) vorgesehen ist und eine Außenfläche aufweist;
- eine Schicht eines belichteten und entwickelten lichtempfindlichen Materials (66), das auf der Außenfläche des festen, optisch klaren Substrates (64) vorgesehen ist, wobei die Schicht des belichteten und entwickelten lichtempfindlichen Materials (66) eine an das feste, optisch klare Substrat (64) angrenzende Innenfläche sowie eine Außenfläche aufweist;
- eine optisch klare Schutzbarriere (68), die auf der Außenfläche des belichteten und entwickelten lichtempfindlichen Materials (66) vorgesehen ist, wobei die optisch klare Schutzbarriere (68) eine an das belichtete und entwickelte lichtempfindliche Material (66) angrenzende Innenfläche und eine AuBenfläche aufweist und
- eine Schicht eines optischen Klebers (70), die auf der Außenschicht der optisch klaren Schutzbarriere (68) vorgesehen ist, wobei der optische Kleber (70) eine Schicht von optisch klarem Material (72) an der Außenfläche der Schutzbarriere (68) anklebt.

14. Optisches Headup-Display nach Anspruch 13, dadurch gekennzeichnet, daß die Außenschicht des optisch klaren Substrates (64) aus der Gruppe von Materialien umfassend inorganische Gläser und organische Polymere mit optischer Qualität ausgewählt ist.

15. Optisches Headup-Display nach Anspruch 13 oder 14, dadurch gekennzeichnet, daß die Schicht des belichteten und entwickelten lichtempfindlichen Materials (66) ein belichtetes und entwickeltes holographisches Aufnahme-Photopolymer ist.

16. Optisches Headup-Display nach irgendeinem der Ansprüche 13 bis 15, dadurch gekennzeichnet, daß die Schutzbarriere (68) Polyvinylalkohol mit einer Dicke von wenigstens 0,5 mils (13 »m) ist.

17. Optisches Headup-Display nach irgendeinem der Ansprüche 13 bis 16, dadurch gekennzeichnet, daß die optische Anzeigebeschichtung (62) eine Antireflexbeschichtung ist.

18. Hologramm umfassend einen holographischen Aufnahmefilm, der zwei Seiten und einen Brechungsindex aufweist, gekennzeichnet durch einen Schutz des holographischen Aufnahmefilms auf wenigstens einer Seite mit einer Schicht von wasserlöslichem Polymer, das einen Brechungsindex besitzt, der im wesentlichen der gleiche wie der Brechungsindex des holographischen Aufnahmefilms ist.

19. Hologramm nach Anspruch 18, dadurch gekennzeichnet, daß das wasserlösliche Polymer Polyvinylalkohol ist.

20. Hologramm nach Anspruch 18 oder 19, dadurch gekennzeichnet, daß der holographische Aufnahmefilm ein Photopolymer ist.

## Revendications

1. Film d'enregistrement photosensible protégé utile à l'enregistrement d'hologrammes, comportant :
- une couche de matière photosensible (12 ; 26 ; 46 ; 66) ayant deux côtés (14, 16 ; 24, 30 ; 44, 48) et un indice de réfraction ; et
- une couche d'arrêt protectrice polymérique à base d'eau, optiquement claire (18, 19 ; 32 ; 52 ; 68) située sur au moins un côté (14, 16 ; 30 ; 50) de ladite matière photosensible (12 ; 26 ; 46; 66), ladite couche d'arrêt protectrice (18, 1 ; 32 ; 52; 68) ayant un indice de réfraction sensiblement égal à l'indice de réfraction de ladite couche de matière photosensible (12 ; 26 ; 46; 66) ;
caractérisé par un substrat optique clair (22 ; 42 ; 64) situé sur un côté de ladite matière photosensible (26 ; 46; 66), ledit substrat optiquement clair (22 ; 42 ; 64) ayant un indice de réfraction sensiblement similaire audit indice de réfraction de ladite couche de matière photosensible (26 ; 46; 66).

2. Film selon la revendication 1, caractérisé en ce que ledit substrat (22 ; 42 ; 64) est en verre et ledit indice de réfraction est d'environ 1,51.

3. Film selon la revendication 1, caractérisé en ce que ledit substrat optiquement clair (22 ; 42 ; 64) est en polycarbonate.

4. Film selon l'une quelconque des revendications 1-3, caractérisé en ce que ladite couche de matière photosensible (12 ; 26 ; 46; 66) est une couche de photopolymère d'enregistrement holographique.

5. Film selon l'une quelconque des revendications 1-4, caractérisé en ce que ladite couche de matière photosensible (12 ; 26 ; 46; 66) a un indice de réfraction d'environ 1,51.

6. Film selon l'une quelconque des revendications 1-5, caractérisé en ce que ladite couche d'arrêt protectrice (18, 19 ; 32 ; 52 ; 68) est en un polymère soluble dans l'eau choisi dans le groupe constitué d'alcool polyvinylique, de gélatine et de polyvinylpyrrolidone.

7. Film selon la revendication 6, caractérisé en ce que ledit polymère soluble dans l'eau est de l'alcool polyvinylique.

8. Film selon la revendication 7, caractérisé en ce que ledit alcool polyvinylique a un indice de réfraction d'environ 1,51.

9. Film d'enregistrement photosensible protégé utile à l'enregistrement d'hologrammes, comportant :
- un substrat (22 ; 42 ; 64) en verre optiquement clair ayant une surface extérieure (24), ledit substrat (22 ; 42 ; 64) en verre optiquement clair ayant un indice de réfraction d'environ 1,51 ;
- une couche de matière photosensible (26 ; 46; 66) située sur la surface extérieure (24) dudit substrat (22 ; 42 ; 64) en verre optiquement clair, ladite couche de matière photosensible (26 ; 46; 66) comprenant un mélange d'un polymère, de monomères d'acrylate, d'initiateurs et d'additifs, ladite couche de matière photosensible (26 ; 46; 66) ayant une surface intérieure (24 ; 48) adjacente audit substrat (22 ; 42 ; 64) en verre optiquement clair et une surface extérieure (30 ; 50) ladite couche de matière photosensible (26 ; 46; 66) ayant un indice de réfraction d'environ 1,51 ; et
- une couche d'arrêt protectrice (32 ; 52 ; 68) en alcool polyvinylique collée à ladite surface extérieure (30 ; 50) de ladite couche de matière photosensible (26 ; 46; 66), ladite couche d'arrêt protectrice (32 ; 52 ; 68) en alcool polyvinylique ayant une épaisseur minimale d'environ 0,5 mils (13 »m) et ayant un indice de réfraction d'environ 1,51.

10. Film selon l'une des revendications 2 ou 9, caractérisé en ce que ledit substrat (42) en verre optiquement clair présente au moins une surface extérieure courbée.

11. Film selon l'une des revendications 2 ou 9, caractérisé en ce que ledit substrat (22 ; 64) en verre optiquement clair présente deux surfaces plates et planes (24).

12. Procédé de préparation d'un film d'enregistrement photosensible protégé comprenant les étapes dans lesquelles :
- on forme une couche d'arrêt protectrice polymérique (18) à base d'eau, optiquement claire, ayant une surface extérieure;
- on forme une couche de matière photosensible (12) sur ladite surface extérieure de ladite couche protectrice polymérique (18) à base d'eau optiquement claire, ladite matière photosensible (12) ayant une surface extérieure (16) ; et
- on fait adhérer une couche d'arrêt protectrice optiquement claire (19) sur ladite surface extérieure (16) de ladite matière photosensible (12).

13. Dispositif de visualisation optique holographique tête haute, comportant :
- une couche de revêtement de visualisation optique (62) ayant une surface extérieure ;
- un substrat rigide optiquement clair (64) situé sur ladite surface extérieure de ladite couche de revêtement de visualisation optique tête haute (62), ledit substrat rigide optiquement clair (64) ayant une surface extérieure ;
- une couche de matière photosensible exposée et traitée (66), située sur ladite surface extérieure dudit substrat rigide optiquement clair (64), ladite couche de matière photosensible exposée et traitée (66) ayant une surface intérieure adjacente audit substrat rigide optiquement clair (64) et une surface extérieure ;
- une couche d'arrêt protectrice optiquement claire (68) située sur ladite surface extérieure de ladite matière photosensible exposée et traitée (66), ladite couche d'arrêt protectrice optiquement claire (68) ayant une surface intérieure adjacente à ladite matière photosensible exposée et traitée (66) et une surface extérieure ; et
- une couche d'adhésif optique (70) située sur ladite couche extérieure de ladite couche d'arrêt protectrice optiquement claire (68) ledit adhésif optique (70) faisant adhérer une couche de matière optiquement claire (72) à ladite surface extérieure de ladite couche d'arrêt protectrice (68).

14. Dispositif de visualisation optique tête haute selon la revendication 13, caractérisé en ce que ladite couche extérieure du substrat optiquement clair (64) est choisie dans le groupe de matières comprenant des verres inorganiques et des polymères organiques de qualité optique.

15. Dispositif de visualisation optique tête haute selon la revendication 13 ou 14, caractérisé en ce que ladite couche de matière photosensible exposée et traitée (66) est un photopolymère d'enregistrement holographique exposé et traité.

16. Dispositif de visualisation optique tête haute selon l'une quelconque des revendications 13-15, caractérisé en ce que ladite couche d'arrêt protectrice (68) est un alcool polyvinylique ayant une épaisseur d'au moins 0,5 mil (13 »m).

17. Dispositif de visualisation optique tête haute selon l'une quelconque des revendications 13-16, caractérisé en ce que ledit revêtement de visualisation optique (62) est un revêtement anti-réflexion.

18. Hologramme comprenant un film d'enregistrement holographique ayant deux côtés et un indice de réfraction, caractérisé en ce que le film d'enregistrement holographique est protégé sur au moins un côté par une couche d'un polymère soluble dans l'eau qui possède un indice de réfraction sensiblement égal à l'indice de réfraction dudit film d'enregistrement holographique.

19. Hologramme selon la revendication 18, caractérisé en ce que ledit polymère soluble dans l'eau est de l'alcool polyvinylique.

20. Hologramme selon la revendication 18 ou 19, caractérisé en ce que ledit film d'enregistrement holographique est en un photopolymère.
